(19) **Europäisches Patentamt**

**European Patent Office**

**Office européen des brevets**

(11) **EP 1 081 578 A2**

(12) **EUROPÄISCHE PATENTANMELDUNG**

(43) Veröffentlichungstag:
07.03.2001 Patentblatt 2001/10

(51) Int. Cl.$^7$: **G06F 1/08**

(21) Anmeldenummer: **00113974.0**

(22) Anmeldetag: **01.07.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **19.07.1999 DE 19933117**

(71) Anmelder:
• **Mannesmann VDO Aktiengesellschaft 60388 Frankfurt am Main (DE)**

• **Fujitsu Microelectronics Europe GmbH 63303 Dreieich-Buchschlag (DE)**

(72) Erfinder:
• **Sattler, Frank, Dr. 64832 Babenhausen (DE)**
• **Klumb, Walter 55278 Mommenheim (DE)**

(74) Vertreter:
**Rassler, Andrea, Dipl.-Phys. Kruppstrasse 105 60388 Frankfurt (DE)**

(54) **Verfahren zur Modulation eines Grundtaktes für digitale Schaltungen und Modulator zur Ausführung des Verfahrens**

(57) Bei einem Verfahren zur Modulation eines Grundtaktes für digitale Schaltungen, bei dem die Abstände benachbarter Schaltflanken verändert werden, wobei der Grundtakt in äquidistante Abschnitte eingeteilt wird und die Abstände der benachbarten Schaltflanken in Abhängigkeit von zyklisch wiederkehrenden Zufallszahlen verändert werden, ist vorgesehen, daß die Lage einer auf eine Schaltflanke ($a_1$) folgende Schaltflanke ($a_{i+1}$) wie folgt berechnet wird:

$$a_{i+1} \left( a_i + p - \left( \frac{N-1}{2} - Z_{i+1} \right) \right) \bmod p$$

wobei

p die Anzahl der äquidistanten Abschnitte pro Halbperiode N die Anzahl der möglichen Schaltflanken, wobei N ungerade ist und Z die Zufallszahl darstellt. Einen entsprechenden Modulator wendet das vorbeschriebene Verfahren entsprechend an.

Fig. 3

**Beschreibung**

Die Erfindung betrifft ein Verfahren zur Modulation eines Grundtaktes für digitale Schaltungen und einen Modulator zur Modulation eines Grundtaktes für digitale Schaltungen. Eine Modulation des Grundtaktes wird angewandt, um Störungen, die durch den Grundtakt verursacht werden, breitbandiger auszugestalten und so die Störungsenergie auf zusätzliche Frequenzen zu verteilen und damit die absoluten Höhen der entstehenden Störungsspitzen zu reduzieren.

Aus der vorangemeldeten Patentanmeldung (DE 198 02 065.1) der Anmelderin ist ein Verfahren zur Modulation eines Grundtaktes für digitale Schaltungen und ein entsprechender Modulator bekannt, bei denen der Grundtakt in äquidistante zeitliche Abschnitte eingeteilt wird und die Anzahl der Abschnitte in Abhängigkeit von zyklisch wiederkehrenden Zufallszahlen verändert wird und so die Abstände der benachbarten Schaltflanken verändert werden.

Dieses Verfahren erreicht entweder eine Phasenmodulation oder eine Frequenzmodulation. Nachteilig bei der Phasenmodulation ist es, daß bei einem solchen Verfahren und einem entsprechenden Modulator der Grundtakt weiterhin einen hohen Pegel besitzt.

Nachteilig bei einem Verfahren mit Frequenzmodulation und entsprechendem Modulator ist es, daß eine Frequenzmodulation erreicht wird, die zwar die Grundfrequenz stark bedämpft, die aber in ihrem zeitlichen Mittel nicht ohne weiteres der Grundfrequenz entspricht. Dadurch können Anwendungen, die eine der Grundfrequenz entsprechende stabile Zeitplattform benötigen, nicht mit dem modulierten Takt betrieben werden.

Aufgabe der Erfindung ist es daher, ein Verfahren für die Frequenzmodulation eines Grundtaktes anzugeben, das einen im Mittel mit dem Grundtakt identischen modulierten Takt abgibt und einen entsprechenden Modulator zur Ausführung des Verfahrens.

Die Aufgabe wird für ein Verfahren dadurch gelöst, daß in dem Verfahren die Lage einer auf eine Schaltflanke $a_1$ folgende Schaltflächen $a_{i+1}$ wie folgt berechnet wird:

$$a_{i+1} = \left( a_i + p - \left( \frac{N-1}{2} - Z_{i+1} \right) \right) \bmod p$$

wobei

p die Anzahl der äquidistanten Abschnitte pro Halbperiode
N die Anzahl der möglichen Schaltflanken, wobei N ungerade ist und
Z die Zufallszahl darstellt.

Hierdurch kann durch entsprechende Auswahl der Zufallszahlen eine modulierte Frequenz f mod erhalten werden, die in ihrem zeitlichen Mittel der Grundfrequenz entspricht. Hierdurch wird es z. B. möglich, mit der modulierten Frequenz eine genaue Zeitbasis für z. B. eine Uhr zur Verfügung zu stellen.

Besonders einfach wird die Auswahl der Zufallszahlen, wenn die Zufallszahlen nach n-Zyklen für n-Zyklen invertiert werden und die invertierten Zahlen dann zur Ableitung der Schaltflanken verwendet werden. Hierdurch wird erreicht, daß auch bei einer ungünstigen Auswahl der verwendeten Zufallszahlen im Mittel die modulierte Frequenz der Grundfrequenz entspricht.

Durch das Leiten des Grundtaktes über Verzögerungseinheiten können die äquidistanten Abschnitte leicht realisiert werden.

Es ist z. B. auch möglich, die äquidistanten Abschnitte durch den Ausgang eines Zählers zu realisieren, der mit einem Vielfachen der zu modulierenden Grundfrequenz betrieben wird.

Dadurch, daß die Verzögerungseinheiten Verzögerungsglieder aufweisen, die einzeln und/oder in Gruppen zu- beziehungsweise weggeschaltet werden, können die äquidistanten Zeitabschnitte verändert werden.

Durch ein Kalibrieren der Verzögerungseinheiten können Änderungen der Betriebsparameter ausgeglichen werden.

Ein erfindungsgemäßer Modulator weist eine Recheneinheit auf, die die Formel aus Anspruch 1 berechnen kann.

Eine besonders einfache Realisierung des Modulators ist dadurch gegeben, daß der zu modulierende Grundtakt über eine Anzahl von Verzögerungseinheiten geleitet wird und die verschiedenen Verzögerungen durch entsprechende Abgriffe zwischen den Verzögerungseinheiten realisiert werden.

Dadurch, daß die Verzögerungszeiten der Verzögerungseinheiten einstellbar sind, ist der Modulator insgesamt für verschiedene Grundfrequenzen und Modulationsgrade verwendbar.

Durch eine Invertierungsvorrichtung zur Invertierung der Zufallszahlen wird die Auswahl der Zufallszahlen einfach. Diese Invertierungsvorrichtung ist nach n-Zyklen der Zufallszahlen zuschaltbar und nach weiteren n-Zyklen wieder abschaltbar. So lange die Zufallszahlen invertiert werden, werden die invertierten Zufallszahlen anstatt der Zufallszahlen zur Ableitung der Abstände benachbarter Schaltflanken verwendet. Hierdurch wird erreicht, daß die durchschnittliche Taktdauer der modulierten Frequenz unabhängig von der Auswahl der Zufallszahlen gleich ist der Dauer des modulierten Grundtaktes.

Die Erfindung wird nachfolgend anhand von Ausführungsbeispielen näher erläutert.

Es zeigen:

Fig. 1 ein Diagramm, das den Grundtakt und die Generierung des modulierten Taktes enthält,

Fig. 2 ein Blockdiagramm eines möglichen Ausführungsbeispiels,

Fig. 3 ein Ausführungsbeispiel eines besonders bevorzugten Modulators,

Fig. 4 ein Funktionsdiagramm des Ausführungsbeispiels aus Fig. 3,

Fig. 5 ein Blockdiagramm eines Ausführungsbeispiels einer Verzögerungseinheit,

Fig. 6 eine Möglichkeit einer approximierten Kalibrierung von in Reihe geschalteten Verzögerungseinheiten

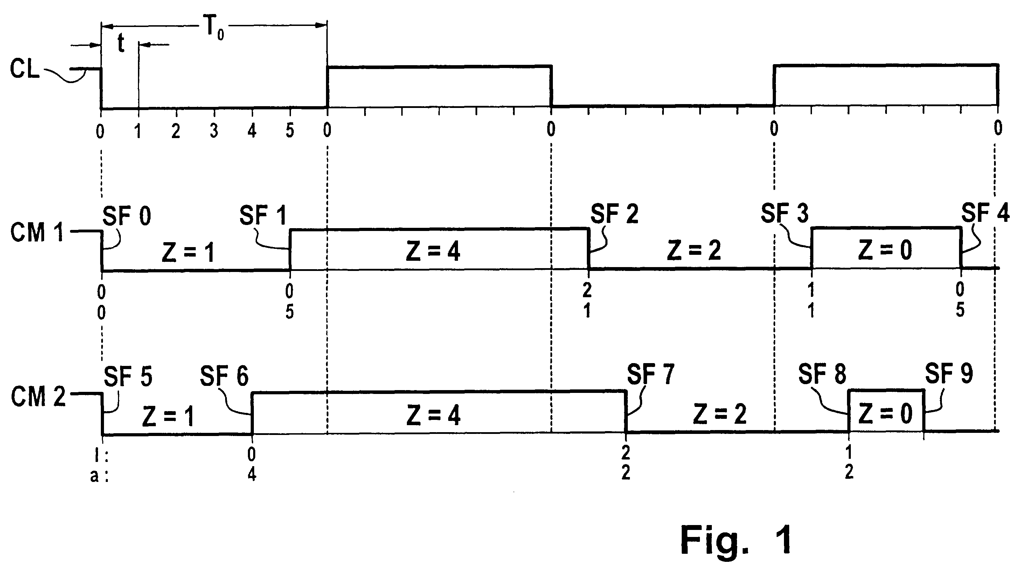

Figur 1 zeigt einen unmodulierten Grundtakt CL, dessen Halbperioden $T_0$ in jeweils 6 Abschnitte mit der Länge t = 1 aufgeteilt sind. Ein Zufallszahlengenerator liefert in periodischen Zyklen 5 unterschiedliche Zufallszahlen Z 0 bis 4. Je nach der Zufallszahl Z und dem Modulationsgrad K werden die Abstände zwischen den einzelnen Schaltflanken des zu modulierenden Taktes bestimmt. So beträgt bei der mittleren Zufallszahl (2) der Abstand zwischen den benachbarten Schaltflanken eine Halbperiode $T_0$. Bei einem Modulationsgrad von 1 ergeben sich für die übrigen Zufallszahlen folgende Abstände der Schaltflanken:

$$0 = 4t$$

$$1 = 5t$$

$$3 = 7t$$

$$4 = 8t$$

Für einen Modulationsgrad von 2 ergeben sich für die Zufallszahlen:

$$0 = 2t$$

$$1 = 4t$$

$$3 = 8t$$

$$4 = 10t$$

Ein Möglichkeit der Berechnung der jeweils nächsten Schaltflanke SF ergibt folgende Gleichung 1:

$$a_{i+i} = \left( a_i + p - \left( \frac{N-1}{2} - Z_{i+1} \right) K \right) \bmod p = X \bmod p \tag{1}$$

weiterhin ergibt sich:

$$x = I * p + a \ x*t$$

wobei I das Intervall ist in dem die nächste Schaltflanke liegt, p die Anzahl der möglichen Schaltpunkte pro Halbperiode $T_0$ und a die Lage der Schaltflanke in dem entsprechenden Intervall.

Die Berechnung der Schaltflanke des modulierten Taktes CM 1 mit dem Modulationsgrad 1 ergibt für die Zufallszahl 1 beim Beginn der letzten Schaltflanke SF 0 mit der Lage a = 0 im Intervall 0:

$$a_{i+1} = \left(0 + 6 - \left(\frac{5-1}{2} - 1\right) \times 1\right) \bmod 6 = 5 \bmod 6$$

$$5 = I * 6 + 5 * 1$$

daraus folgt

$$I = 0 \qquad a = 5$$

Dies besagt, daß die Schaltflanke SF 1 im selben Intervall bei a = 5 liegt. Sofern I = 1 beträgt, liegt die nächste Schaltflanke im nächsten Intervall, bei I = 2 liegt die Schaltflanke im übernächsten Intervall.
Für die Schaltflanke SF 2 ergibt sich:

$$a_{i+1} = \left(5 + 6 - \left(\frac{5-1}{2} - 4\right) * 1\right) \bmod 6 = 13 \bmod 6$$

$$13 = I * 6 + a * 1$$

$$I = 2 \qquad a = 1$$

Dies bedeutet, die Schaltflanke SF 2 liegt im übernächsten Intervall bei dem Wert a = 1.
Für die Schaltflanke SF 3 ergibt sich:

$$a_{i+1} = \left(1 + 6 - \left(\frac{5-1}{2} - 2\right) * 1\right) \bmod 6 = 7 \bmod 6$$

$$7 = I * 6 + a * 1$$

$$I = 1 \qquad a = 1$$

Für die Schaltflanke SF 4 ergibt sich entsprechend:

$$a_{e+1} = \left(1 + 6 - \left(\frac{5-1}{2} - 0\right) * 1\right) \bmod 6 = 5 \bmod 6$$

$$5 = I * 6 + a * 1$$

$$I = 0 \qquad a = 5$$

Dies bedeutet, daß die Schaltflanke SF 4 im gleichen Intervall an der Stelle 5 liegt.
Für den Takt CM 2 mit dem Modulationsgrad 2 ergeben sich für die Schaltflanken SF 6 bis SF 9:
Für die Schaltflanke SF 6:

$$a_{i+1} = \left(0 + 6 - \left(\frac{5-1}{2} - 1\right) * 2\right) \bmod 6 = 4 \bmod 6$$

$$4 = I * 6 + a * 1$$

$$I = 0 \qquad a = 4$$

Für die Schaltflanke SF 7:

$$a_{i+1} = \left(4 + 6 \cdot \left(\frac{5-1}{2} - 4\right) * 2\right) \bmod 6 = 14 \bmod 6$$

$$14 = I * 6 + a * 1$$

$$I = 2 \qquad a = 2$$

Für die Schaltflanke SF 8:

$$a_{i+1} = \left(2 + 6 \cdot \left(\frac{5-1}{2} - 2\right) * 2\right) \bmod 6 = 8 \bmod 6$$

$$6 = I * 6 + a * 1$$

$$I = 1 \qquad a = 2$$

Für die Schaltflanke SF 9:

$$a_{i+1} = \left(2 + 6 \cdot \left(\frac{5-1}{2} - 0\right) \times 2\right) \bmod 6 = 4 \bmod 6$$

$$4 = I * 6 + a * 1$$

$$I = 0 \qquad a = 4$$

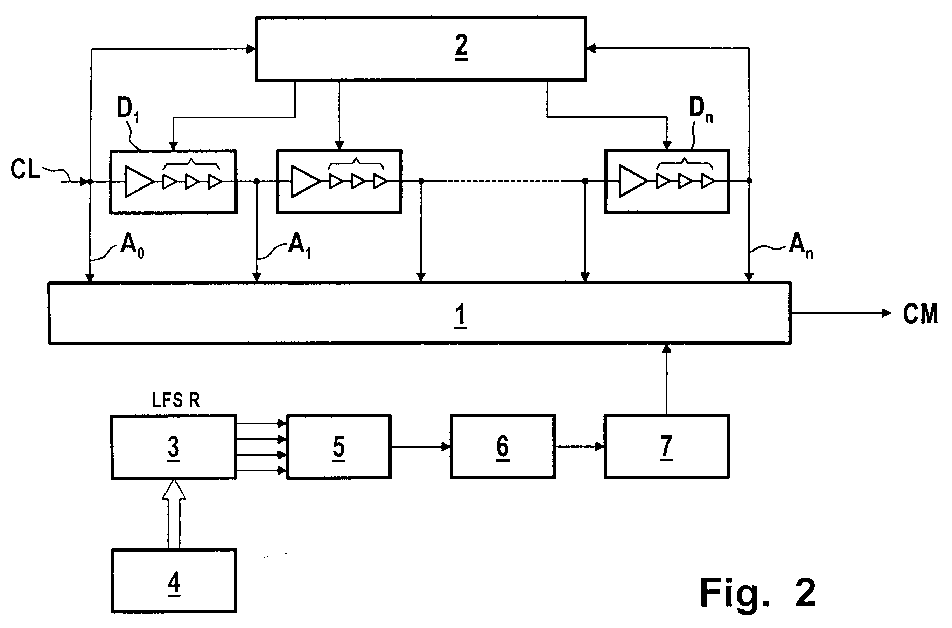

Das Blockdiagramm eines Ausführungsbeispiels des erfindungsgemäßen Modulators in Figur 2 weist n in Reihe geschaltete Verzögerungseinheiten $D_1$ bis $D_n$ mit davor und dahinterliegenden Abgriffen $A_0$ bis $A_n$ die mit einem Multiplexer 1 verbunden sind. Die einzelnen Verzögerungseinheiten $D_1$ bis $D_n$ erzeugen jeweils eine Verzögerung der Länge

$$t = \frac{2 T_o}{n}$$

so daß die vollständige Verzögerungsreihe den am Eingang 6 anliegenden unmodulierten Grundtakt CL um insgesamt eine Periode verzögern. Eine Kalibriervorrichtung 2 vergleicht den am Eingang E anliegenden Grundtakt CL mit dem am Ausgang $A_n$ des letzten Verzögerungsgliedes $D_n$ anliegenden Signals. Stimmen die Zeitpunkte der Schaltflanken der beiden Signale nicht überein, kalibriert die Kalibriervorrichtung 2 die Verzögerungseinheiten $D_1$ bis $D_n$ so, daß die beiden Signale übereinstimmen.

Mit Hilfe eines rückgekoppelten Schieberegisters 3 werden m Zufallszahlen zyklisch erzeugt.

Sobald ein Zyklus der Zufallszahlen beendet ist, werden während des nachfolgenden Zyklus mit einem Invertierer 5 die aus dem rückgekoppelten Schiebregister ausgelesenen Zufallszahlen invertiert, um eine gleichmäßige Verteilung der Zufallszahlen und damit der unterschiedlichen Verzögerungen zu erhalten. Wenn eine gerade Anzahl von verschiedenen Zufallszahlen vorhanden ist, wird diese in einer Mapvorrichtung 6 um eins reduziert, so daß eine ungerade Anzahl von verschiedenen Zufallszahlen gegeben ist. Diese Reduzierung kann zum Beispiel dadurch realisiert sein, daß beim Vorliegen der höchsten Zufallszahl nicht diese genommen wird, sondern nacheinander die übrigen Zufallszahlen. Dies kann zum Beispiel dadurch geschehen, daß beim Vorliegen dieser höchsten Zufallszahl ein Zähler, der von Null bis zu der noch erlaubten höchsten Zufallszahl zählt, ausgelesen wird und dann um eins hochgesetzt wird.

Die so erhaltenen Zufallszahlen werden, wie zuvor zu Figur 1 beschrieben, in der Recheneinheit 7 verwendet, um den Abgriff $A_0$ bis $A_n$ zu bestimmen, auf der Multiplexer 1 geschaltet werden muß, damit die der Zufallszahl und dem Modulationsgrad entsprechende Schaltflanke erzielt wird.

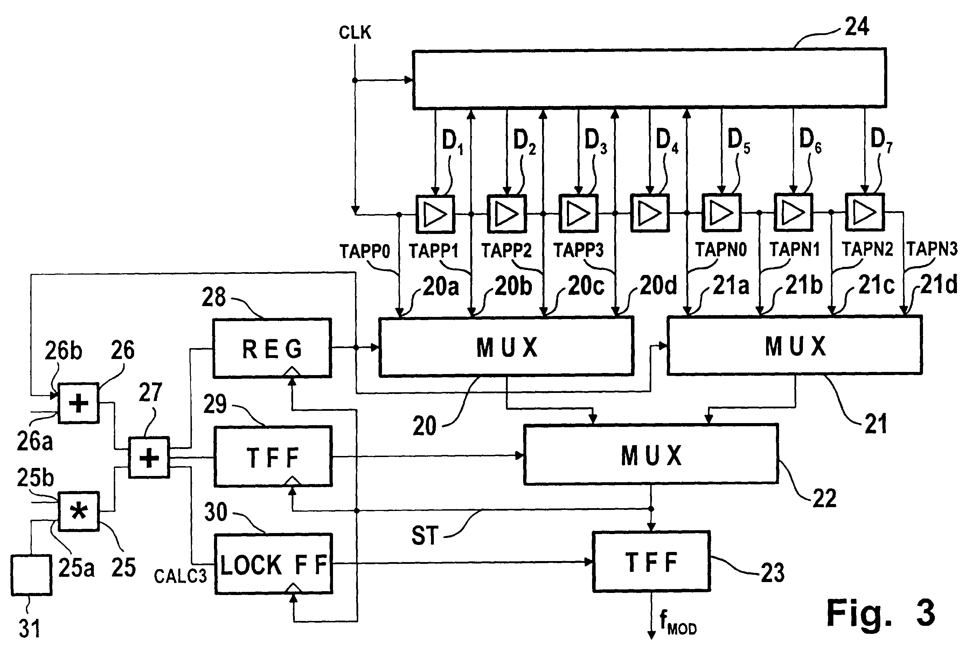

In Figur 3 sind 7 Verzögerungseinheiten $D_1 — D_7$ zu einer Verzögerungskette in Reihe geschaltet, über die der Grundtakt CLK geleitet wird. Der Grundtakt CLK (entsprechend dem Signal TAPP0) und die Signale TAPP1 — P3, die die Verzögerungseinheiten $D_1 — D_3$ verlassen, liegen jeweils an einem Eingang 20a - d eines Multiplexers 20 an, die Signale TAP N0 — N3, die die Verzögerungseinheiten $D_4 — D_7$ verlassen, an jeweils einem Eingang 21a - d des Multiplexers 21. Die Ausgänge der Multiplexer 20, 21 sind mit den Eingängen eines Multiplexers 22 verbunden, dessen Ausgang an den Eingang eines Toggle Flipflop 23 anliegt, an dessen Ausgang der modulierte Takt $f_{MOD}$ anliegt.

Die Signale TAPP0 — TAPP3 werden zusätzlich auch an eine Kalibriereinheit 24 gegeben, die überwacht, ob die Verzögerung dieser Signale korrekt ist. Ist dies nicht der Fall, werden die Verzögerungseinheiten $D_1$ - $D_4$ so lange kalibriert bis die Verzögerung stimmt. Die für Verzögerungseinheiten $D_1$ — $D_4$ ermittelten Werte werden auch für die Verzögerungseinheiten $D_5$ bis $D_7$ übernommen, da sie die gleichen Betriebsparameter aufweisen wie die Verzögerungseinheiten $D_1$ — $D_4$, insbesondere wenn alle Verzögerungseinheiten $D_1$ — $D_7$ oder sogar der gesamte Modulator in einem IC integriert sind. Diese Kalibrierung kann ständig oder in bestimmten zeitlichen Abständen erfolgen oder beispielsweise bei Änderungen bestimmter Parameter wie beispielsweise Temperatur oder Schaltung durchgeführt werden.

Figur 3 zeigt weiterhin einen Multiplizierer 25, zwei Addierer 26, 27, ein Register 28, ein Toggle-Flipflop 29, ein Lock-Flipflop 30 und einen Zufallszahlengenerator 31.

Die Gleichung 1 läßt sich folgendermaßen umschreiben:

$$S = a_{i+1} = (a_i + K * Z_{i+1} + c) \bmod p$$

$$\text{wobei } c = p - ((N-1):2) * K$$

Am Eingang 25a liegt die nächste Zufallszahl $Z_{i+1}$ an, am Eingang 25b der Modulationsgrad K, am Eingang 26a liegt die Konstante c an und am Eingang 26b die Lage $a_i$ der vorhergehenden Schaltflanke SF, die aus dem Register 28 ausgelesen wird. Das Produkt aus dem Multiplizierer 25 und die Summe aus dem Addierer 26 werden im Addierer 27 zu einer Summe S zusammengezählt. Das oberste Bit dieser Summe S wird an den Setzeingang des Lock-Flipflop 30 geführt, das zweithöchste Bit an den Eingang des Toggle-Flipflop 29 und die beiden restlichen, unteren Bit an das Register 28. Der Ausgang des Registers 28 steuert die beiden Multiplexer 25, 26 an und wird weiterhin auf einen Eingang des Addierers 26 zurückgekoppelt.

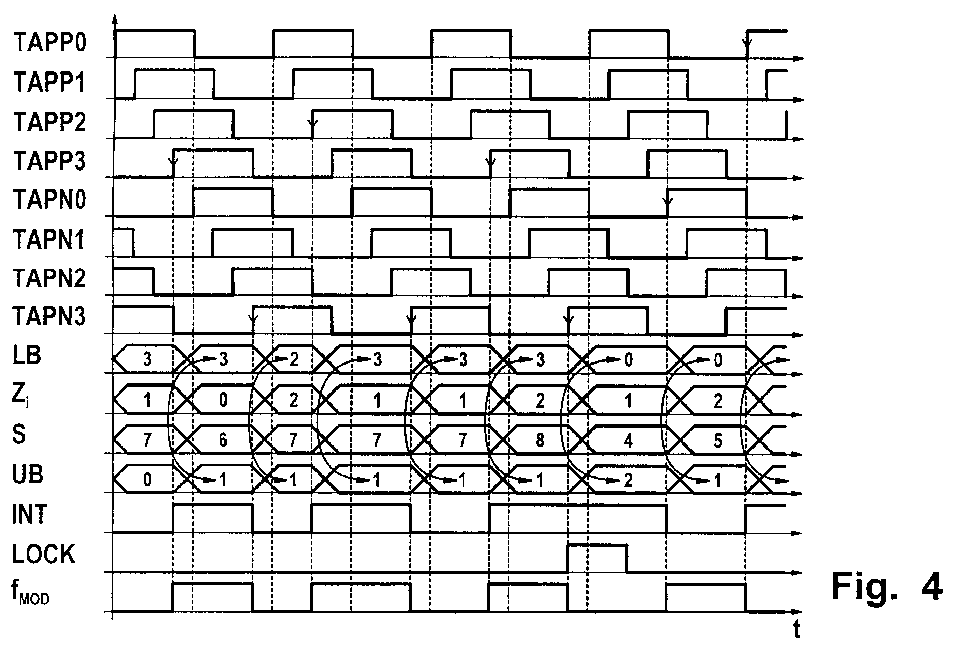

In Figur 4 ist eine beispielhafte Darstellung der Funktionsweise des vorbeschriebenen Modulators in Form eines Diagramms dargestellt. Hierbei bedeuten TAPP0 bis TAPP3 die Signale, die an den Eingängen des Multiplexers 20, TAPN0 bis N3 die Signale, die an den Eingängen des Multiplexers 21 anliegen. LB bedeutet die Zahl die die untersten beiden Bit der Summe S ergeben und repräsentiert damit die Nummer des Signals TAPP0 — TAPP3 bzw. TAPN0 — TAPN3, $Z_i$ die jeweils vorliegende Zufallszahl, UB die Zahl der beiden oberen Bit der Summe S, INT den Ausgang des Toggle-Flipflop 29 und LOCK den Ausgang des Lock-Flipflop 30.

Die Anzahl der möglichen Zufallszahlen Z sei = 3, nämlich 0,1 und 2, die Anzahl der möglichen Schaltpunkte p pro Halbperiode $T_0$ ist 4 (nämlich jeweils die steigende Flanke von TAPP0 bis P3 bzw. TAPN0 bis N3) und der Modulationsgrad sei K = 1.

Somit kann die Summe S Werte von 3 bis 8 betragen, digital geschrieben:

|   | UB | LB |
|---|----|----|
| 3 | 00 | 11 |
| 4 | 01 | 00 |
| 5 | 01 | 01 |
| 6 | 01 | 10 |
| 7 | 01 | 11 |
| 8 | 10 | 00 |

Die Modulation beginnt mit dem Wert 3 im Register 28, die Zufallszahl $Z_i$ = 1 und die Ausgänge der Flipflop 29, 30 seien auf 0. Wenn am Eingang des Multiplexers 22 der Wert 0 anliegt, schaltet er auf den Multiplexer 20 durch, beim Wert 1 auf den Multiplexer 21. Die 3 bedeutet, daß der Eingang TAPP3 bzw. TAPPN 3 der Multiplexer 21 durchgeschaltet wird, so daß das Signal, das nach der Verzögerungseinheit D3 anliegt, durchgeschaltet wird, das bei seiner nächsten positiven Flanke den Ausgang des Toggle-Flipflop 23 umschalten wird.

Der parallel dazu berechnete nächste durchzuschaltende Eingang:

$$S = 3 + 1 \times 1 + 3 = 7 \text{ oder binär } 0\,1\,1\,1$$

wird mit der nächsten positiven Flanke des Signals ST, das den Multiplexer 22 verläßt, in das Register 28 , das Toggle-Flipflop 29 und das Lock-Flipflop 30 übernommen. Somit weisen die unteren beiden Bit UB = 11 = 3 und die oberem Bit 01 = 1 auf. Im Register 28 steht also eine 3, so daß die Eingägen TAPP3 und TAPN3 durchgeschaltet werden, das zweithöchste Bit ist eine 1, so daß das Toggle-Flipflop 29 seinen Ausgang umschaltet, und zwar von der 0 auf die 1, so daß das Signal am Ausgang von Multiplexer 21 durchgeschaltet wird. Somit schaltet die positive Flanke von TAPN3 das Toggle-Flipflop 23 wieder auf 0. Die weitere Berechnung läuft entsprechend. Wenn die Summe S = 8 beträgt, digital 1000, sperrt das Lock-Flipflop 30 das Toggle-Flipflop 23, so daß es nicht seinen Ausgang ändern kann.

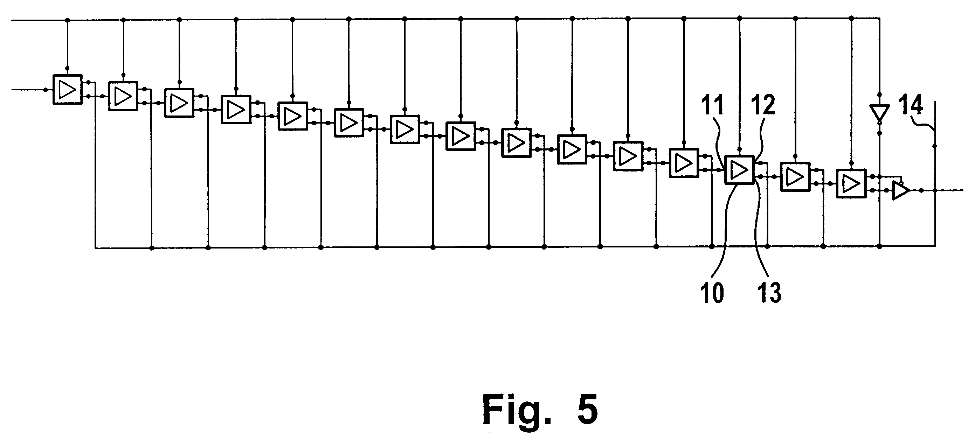

In Figur 5 erkennt man den möglichen Aufbau einer Verzögerungseinheit D. Die Verzögerungseinheit D besteht aus m in Reihe geschalteten Verzögerungsgliedern 10. Die Verzögerungsglieder 10 weisen jeweils einen Takteingang 11, zwei Taktausgänge 12, 13 und einen Steuereingang 14 auf. Der jeweilige Taktausgang 12 ist mit dem Ausgang 14 der Verzögerungseinheit D verbunden, während der jeweilige Taktausgang 13 mit dem Takteingang 11 des jeweils folgenden Verzögerungsgliedes 10 verbunden ist. Durch die Steuereingänge 14 wird bestimmt, an welchem Taktausgang 12, 13 das (verzögerte) Taktsignal anliegt und damit, ob das Taktsignal weiterverzögert werden soll oder unverzögert zum Ausgang 14 gelangen soll. Somit läßt sich die Verzögerungszeit jeder Verzögerungseinheit D in großem Bereich variieren.

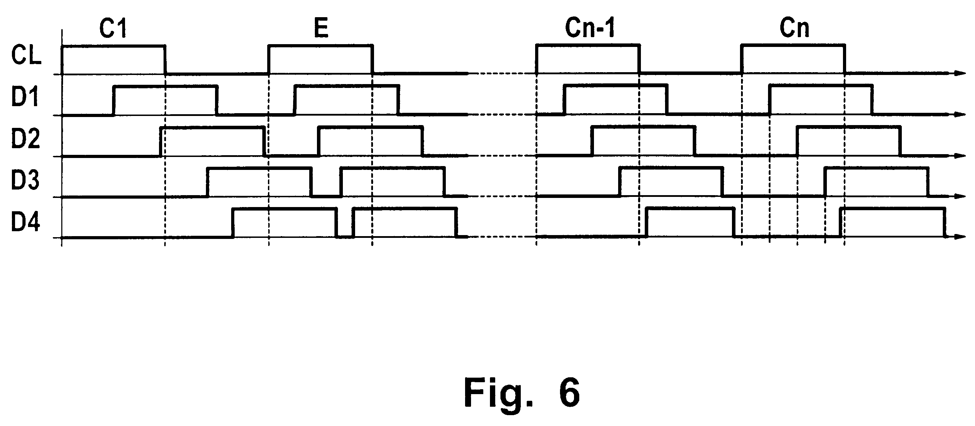

Das Ablaufdiagramm in Fig. 6 zeigt eine Möglichkeit einer approximierten Kalibrierung der Verzögerungseinheiten aus Fig. 3. Zunächst werden im ersten Zyklus C1 in jeder Verzögerungseinheit D1- D4 die gleiche Anzahl von Verzögerungsgliedern eingesetzt, um den Takt CL zu verzögern. Da bei der Verzögerungseinheit D4 der Takt mehr als eine vollständige halbe Periode verzögert ist, werden in den Verzögerungseinheiten D1 - D4 jeweils eine gleiche Anzahl von Verzögerungsgliedern weggeschaltet. Dies wird in mehreren Schritten mit abnehmender Anzahl durchgeführt, bis durch Zu- oder Wegschalten jeweils eines Verzögerungsgliedes in jeder Verzögerungseinheit bei der Verzögerungseinheit D4 der Takt um fast eine halbe Periode verzögert ist und das Ende E der Grobkalibrierung erreicht ist. Dann werden während der Feinkalibrierung einzelne Verzögerungsglieder in einigen oder einer Verzögerungseinheit zu- oder weggeschaltet, bis im vorletzten Schritt Cn-1 bei der Verzögerungseinheit D4 der Takt um mehr als eine halbe Periode verzögert ist, um dann im letzten Schritt Cn durch Wegschalten eines Verzögerungsgliedes die Reihe der Verzögerungseinheiten so kalibriert zu haben, daß bei der Verzögerungseinheit D4 der Takt um weniger als die Zeitdauer der Verzögerung eines Verzögerungsgliedes kürzer als eine halbe Periode eines Taktes verkürzt wird.

Die Verzögerungseinheiten D5 — D7 werden dann entsprechend eingestellt.

Es ist auch möglich, alle Verzögerungseinheiten D1 - D7 gleichzeitig abzugleichen, wenn nach der Verzögerungseinheit D7 noch eine weitere, nicht dargestellte Verzögerungseinheit angeordnet ist und die Verzögerungseinheiten solange in der vorbeschriebenen Weise abgeglichen werden durch Zu- beziehungsweise Wegschalten von Verzögerungsgliedern, bis der Takt am Ausgang der nicht dargestellten Verzögerungseinheit um die Dauer einer vollen Periode verzögert ist.

## Patentansprüche

1.  Verfahren zur Modulation eines Grundtaktes für digitale Schaltungen, bei dem die Abstände benachbarter Schaltflanken verändert werden, wobei der Grundtakt in äquidistante Abschnitte eingeteilt wird und die Abstände der benachbarten Schaltflanken in Abhängigkeit von zyklisch wiederkehrenden Zufallszahlen verändert werden, **dadurch gekennzeichnet**, daß die Lage einer auf eine Schaltflanke ($a_1$) folgende Schaltflanke ($a_{i+1}$) wie folgt berechnet wird:

$$a_{i+1} = \left( a_i + p - \left( \frac{N-1}{2} - Z_{i+1} \right) \right) \bmod p$$

wobei

p die Anzahl der äquidistanten Abschnitte pro Halbperiode
N die Anzahl der möglichen Schaltflanken, wobei N ungerade ist und
Z die Zufallszahl darstellt.

2.  Verfahren nach Anspruch 1, **dadurch gekennzeichnet**, daß zusätzlich ein Modulationsgrad K eingeführt wird, so daß sich ergibt:

$$a_{i+1} = \left( a_i + p - \left( \frac{N-1}{2} - Z_{i+1} \right) K \right) \bmod p$$

3. Verfahren nach Anspruch 1 oder 2, **dadurch gekennzeichnet**, daß die Zufallszahlen nach n-Zyklen für n-Zyklen invertiert werden und diese invertierten Zufallszahlen zur Ableitung der benachbarten Schaltflanken verwendet werden.

4. Verfahren nach einem der vorhergehenden Ansprüche, **dadurch gekennzeichnet**, daß der Grundtakt über eine wechselnde Anzahl von Verzögerungseinheiten geleitet wird und so die Abstände der benachbarten Schaltflanken verändert werden.

5. Verfahren nach Anspruch 4, **dadurch gekennzeichnet**, daß die Verzögerungseinheiten jeweils mehrere Verzögerungsglieder aufweisen, die einzeln und/oder in Gruppen zu- beziehungsweise weggeschaltet werden.

6. Verfahren nach Anspruch 4 oder 5, **dadurch gekennzeichnet**, daß die Verzögerungszeiten der Verzögerungseinheiten (D1 - Dn) kalibriert werden.

7. Verfahren nach Anspruch 6, **dadurch gekennzeichnet**, daß zur Kalibrierung der Verzögerungseinheiten (D1 - Dn) die Verzögerungsglieder (10) stufenweise approximiert zu- beziehungsweise weggeschaltet werden.

8. Verfahren nach Anspruch 7, **dadurch gekennzeichnet**, daß zunächst während eines Grobabgleichs in allen Verzögerungseinheiten (D1 - Dn) jeweils die gleiche Anzahl Verzögerungsglieder (10) zu- beziehungsweise weggeschaltet wird und dann in einem Feinabgleich jeweils ein Verzögerungsglied (10) in einer oder mehreren Verzögerungseinheiten (D1 - Dn) zu- oder weggeschaltet wird.

9. Verfahren nach Anspruch 7, **dadurch gekennzeichnet**, daß in einer Reihe von Verzögerungseinheiten (D1 - D4), die sich von der ersten Verzögerungseinheit (D1) bis zu der Verzögerungseinheit (D4) erstreckt, an deren Ausgang bei korrekter Verzögerung der Takt um eine halbe Periode verzögert wird, während eines Grobabgleichs in allen Verzögerungseinheiten (D1 - D4) jeweils die gleiche Anzahl Verzögerungsglieder (10) zu- beziehungsweise weggeschaltet wird und dann in einem Feinabgleich jeweils ein Verzögerungsgleid (10) in einer oder mehreren Verzögerungseinheiten (D1 - D4) zu- oder weggeschaltet wird, bis am Ausgang der letzten Verzögerungseinheit (D4) der Reihe der Takt um eine halbe Periode verzögert wird, daß anschließend die restlichen Verzögerungseinheiten (D5 - D7) entsprechend eingestellt werden.

10. Modulator zur Modulation eines Grundtaktes für digitale Schaltungen, bei dem die Abstände benachbarter Schaltflanken verändert werden, wobei der Grundtakt in äquidistante Abschnitte eingeteilt wird und die Abstände der benachbarten Schaltflanken in Abhängigkeit von zyklisch wiederkehrenden Zufallszahlen veränderbar sind, **dadurch gekennzeichnet**, daß die Lage einer auf eine Schaltflanke ($a_1$) folgende Schaltflanke ($a_{i+1}$) in einer Recheneinheit wie folgt berechenbar ist:

$$a_{i+1} = \left( a_i + p - \left( \frac{N\text{-}1}{2} \cdot Z_{i+1} \right) \right) \bmod p$$

wobei

p die Anzahl der äquidistanten Abschnitte pro Halbperiode
N die Anzahl der möglichen Schaltflanken, wobei N ungerade ist und
Z die Zufallszahl darstellt.

11. Modulator nach Anspruch 10, **dadurch gekennzeichnet**, daß ein Modulationsgrad (K) wählbar ist, so daß sich folgende Formel ergibt:

$$a_{i+1} = \left( a_i + p - \left( \frac{N\text{-}1}{2} \cdot Z_{i+1} \right) K \right) \bmod p$$

12. Modulator nach Anspruch 10 oder 11, **dadurch gekennzeichnet**, daß die Zufallszahlen nach n-Zyklen für n-Zyklen invertierbar sind und diese invertierten Zufallszahlen zur Ableitung der benachbarten Schaltflanken verwendbar sind.

13. Modulator, nach einem der Ansprüche 10 bis 12, **dadurch gekennzeichnet**, daß er eine in Reihe geschaltete Anzahl von Verzögerungseinheiten aufweist, wobei zwischen den Verzögerungseinheiten Abgriffe angeordnet sind und der Grundtakt über eine wechselnde Anzahl von Verzögerungseinheiten leitbar und so der Abstand zwischen den Schaltflanken veränderbar ist.

14. Modulator nach Anspruch 13, **dadurch gekennzeichnet**, daß die Verzögerungszeiten der Verzögerungseinheiten einstellbar und kalibrierbar sind.

15. Modulator nach Anspruch 14, **dadurch gekennzeichnet**, daß die Verzögerungseinheiten in Reihe geschaltete Verzögerungsglieder aufweisen, die einzeln zu- und abschaltbar sind.

16. Modulator nach einem der Ansprüche 10 bis 15, **dadurch gekennzeichnet**, daß eine Invertierungsvorrichtung zur Invertierung der Zufallszahlen vorhanden ist, daß die Invertierungsvorrichung nach n-Zyklen zu und nach weiter n-Zyklen wieder abschaltbar ist, daß aus den invertierten Zufallszahlen statt aus den Zufallszahlen die Abstände benachbarter Schaltflanken ableitbar sind.

**Fig. 1**

EP 1 081 578 A2

Fig. 2

EP 1 081 578 A2

Fig. 3

Fig. 4

Fig. 5

Fig. 6

EP 1 081 578 A2